# EUROPÄISCHE PATENTANMELDUNG

(11) **EP 1 645 578 A1**
(43) Veröffentlichungstag der Anmeldung: **12.04.2006**
(21) Anmeldenummer: 05020049.2
(22) Anmeldetag: 15.09.2005
(51) Int. Cl.: C08G 18/08, C08K 5/3472, C08K 5/3475

(54) **Kaschierklebstoff für die Kaschierung von Kunststoff auf Metall**

(30) Priorität: 11.10.2004 DE 102004049637
(71) Anmelder: BASF Aktiengesellschaft, 67056 Ludwigshafen (DE)
(72) Erfinder: Türk, Johannes, 67459 Böhl-Iggelheim (DE); Malz, Hauke, Dr., 49356 Diepholz (DE); Schumacher, Karl-Heinz, Dr., 67433 Neustadt (DE); Häberle, Karl, Dr., 67346 Speyer (DE)

(57) **Zusammenfassung**

Wässrige Polyurethandispersionen, enthaltend einen Metalldeaktivator.

## Beschreibung

Die Erfindung betrifft wässrige Polyurethandispersionen, enthaltend einen Metalldeaktivator.

Weiterhin betrifft die Erfindung die Verwendung der Polyurethandispersionen zum Kaschieren von Metall und Folienflachleiter und Leiterplatten, erhältlich durch eine derartige Verwendung.

Folienflachleiter und Leiterplatten werden häufig so hergestellt, dass ein leitendes Metall, meist Kupfer, zur Isolierung mit einem Kunststoff, meist in Form von Kunststofffolien, kaschiert wird. Zur Herstellung eines haftenden Verbundes zwischen Metall und Kunststoff wird meist ein Klebstoff verwendet. Besonders geeignete Klebstoffe hierfür sind Polyurethane, wobei wegen ihrer hohen Klebkraft und ihrer geringen Umweltbelastung häufig wässrige Polyurethan-Dispersionen verwendet werden. Allerdings wird dabei manchmal beobachtet, dass es zu Korrosionserscheinungen am Metall kommt.

Triazolderivate sind als Metalldeaktivatoren z.B. aus DE-A-10218911 bekannt. In dieser Anmeldung ist der Zusatz von Triazolderivaten zu Polyurethanfolien und die Verwendung der Folien zur Herstellung von Folienflachleitern und Leiterplatten beschrieben.

Aufgabe der Erfindung waren daher wässrige Polyurethandispersionen, welche sich für die Herstellung von Folienflachleitern und Leiterplatten eignen, Korrosionserscheinungen am Metall mindern oder verhindern und eine unvermindert hohe Klebekraft haben.

Demgemäß wurden die eingangs definierten Polyurethandispersionen und ihre Verwendung für Folienflachleiter und Leiterplatten gefunden.

Polyurethane und die diese enthaltenen wässrigen Dispersionen sind allgemein bekannt.

Bevorzugt sind derartige Polyurethane aufgebaut aus
Ia) Diisocyanaten mit 4 bis 30 C-Atomen,
Ib) Diolen, von denen
   Ib1) 10 bis 100 mol%, bezogen auf die Gesamtmenge der Diole (IIb), ein Molekulargewicht von 500 bis 5000 aufweisen, und
   Ib2) 0 bis 90 mol-%, bezogen auf die Gesamtmenge der Diole, ein Molekulargewicht von 60 bis 500 g/mol aufweisen,
Ic) von den Monomeren (Ia) und (Ib) verschiedene Monomere mit wenigstens einer Isocyanatgruppe oder wenigstens einer gegenüber Isocyanatgruppen reaktiven Gruppe, die darüberhinaus wenigstens eine hydrophile Gruppe oder eine potentiell hydrophile Gruppe tragen, wodurch die Wasserdispergierbarkeit der Polyurethane bewirkt wird,
Id) gegebenenfalls weiteren von den Monomeren (la) bis (Ic) verschiedenen mehrwertigen Verbindungen mit reaktiven Gruppen, bei denen es sich um alkoholische Hydroxylgruppen, primäre oder sekundäre Aminogruppen oder Isocyanatgruppen handelt und
Ie) gegebenenfalls von den Monomeren (la) bis (Id) verschiedenen einwertigen Verbindungen mit einer reaktiven Gruppe, bei der es sich um eine alkoholische Hydroxylgruppe, eine primäre oder sekundäre Aminogruppe oder eine Isocyanatgruppe handelt.

Als Monomere (Ia) kommen die üblicherweise in der Polyurethanchemie eingesetzten aliphatischen oder aromatischen Diisocyanate in Betracht. Bevorzugt sind die Monomere (IIa) oder deren Mischungen, die auch als Monomere (la) in der DE-A-19521500 erwähnt sind.

Als Monomere (Ib) und (Id) kommen bevorzugt die in der DE-A-19521500 genannten in Betracht.

Monomere Ib1 sind beispielsweise Polyester- oder Polyetherdiole.

Bei den Monomeren Ib2 handelt es sich beispielsweise um aliphatische Diole mit 2 bis 12 C-Atomen, z.B. 1,4-Butandiol oder 1,6-Hexandiol.

Als Monomere (Id) sind beispielsweise aliphatische Amine mit 2 bis 12 C-Atomen und 2 bis 4 Gruppen, ausgewählt aus der Gruppe der primären oder sekundären Aminogruppen, geeignet. Beispiele sind Ethylendiamin, Isophorondiamin oder Diethylentriamin.

Um die Wasserdispergierbarkeit der Polyurethane zu erreichen, sind die Polyurethane neben den Komponenten (la), (Ib) und (Id) aus von den Komponenten (Ia), (Ib) und (Id) verschiedenen Monomere (Ic), die wenigstens eine Isocyanatgruppe oder wenigstens eine gegenüber Isocyanatgruppen reaktive Gruppe und darüberhinaus wenigstens eine hydrophile Gruppe oder eine Gruppe, die sich in eine hydrophile Gruppe überführen lässt (potentiell hydrophile Gruppe), tragen, aufgebaut. Im folgenden Text wird der Begriff "hydrophile Gruppen oder potentiell hydrophile Gruppen" mit "(potentiell) hydrophile Gruppen" abgekürzt. Die (potentiell) hydrophilen Gruppen reagieren mit Isocyanaten wesentlich langsamer als die funktionellen Gruppen der Monomere, die zum Aufbau der Polymerhauptkette dienen.

Bevorzugte Monomere (Ic) sind ebenfalls die in der DE-A-19521500 als Monomere (Ic) bezeichneten.

Der Anteil der Komponenten mit (potentiell) hydrophilen Gruppen an der Gesamtmenge der Komponenten (Ia), (Ib), (Ic), (Id) und (Ie) wird im allgemeinen so bemessen, dass die Molmenge der (potentiell) hydrophilen Gruppen, bezogen auf die Gewichtsmenge aller Monomere (a) bis (e), 80 bis 1200, bevorzugt 100 bis 1000 und besonders bevorzugt 150 bis 800 mmol/kg beträgt.

Bei den (potentiell) hydrophilen Gruppen kann es sich um nichtionische, z.B. Polyethylenoxidgruppen oder bevorzugt um (potentiell) ionische hydrophile Gruppen, z.B. Carboxylat- oder Sulfonat-Gruppen handeln. Bevorzugt wird ohne wirksame Mengen an nichtionischen Gruppen gearbeitet.

Der Gehalt an nichtionischen hydrophilen Gruppen, falls solche eingebaut werden, beträgt im allgemeinen bis 5, bevorzugt bis 3, besonders bevorzugt bis 1 Gew.-%, bezogen auf die Gewichtsmenge aller Monomere (Ia) bis (Ie).

Monomere (Ie), die gegebenenfalls mitverwendet werden, sind Monoisocyanate, Monoalkohole und mono-primäre und -sekundäre Amine. Im allgemeinen beträgt ihr Anteil maximal 10 mol-%, bezogen auf die gesamte Molmenge der Monomere. Diese monofunktionellen Verbindungen tragen üblicherweise weitere funktionelle Gruppen wie Carbonylgruppen und dienen zur Einführung von funktionellen Gruppen in das Polyurethan, die die Dispergierung bzw. die Vernetzung oder weitere polymeranaloge Umsetzung des Polyurethans ermöglichen.

Auf dem Gebiet der Polyurethanchemie ist allgemein bekannt, wie das Molekulargewicht der Polyurethane durch Wahl der Anteile der miteinander reaktiven Monomere sowie dem arithmetischen Mittel der Zahl der reaktiven funktionellen Gruppen pro Molekül eingestellt werden kann.

Normalerweise werden die Komponenten (Ia) bis (Ie) sowie ihre jeweiligen Molmengen so gewählt, daß das Verhältnis A : B mit
A) der Molmenge an Isocyanatgruppen und
B) der Summe aus der Molmenge der Hydroxylgruppen und der Molmenge der funktionellen Gruppen, die mit Isocyanaten in einer Additionsreaktion reagieren können

0,5 : 1 bis 2 : 1, bevorzugt 0,8 : 1 bis 1,5, besonders bevorzugt 0,9 : 1 bis 1,2 : 1 beträgt. Ganz besonders bevorzugt liegt das Verhältnis A : B möglichst nahe an 1 : 1.

Die eingesetzten Monomere (Ia) bis (Ie) tragen im Mittel üblicherweise 1,5 bis 2,5, bevorzugt 1,9 bis 2,1, besonders bevorzugt 2,0 Isocyanatgruppen bzw. funktionelle Gruppen, die mit Isocyanaten in einer Additionsreaktion reagieren können.

Die verschiedenen Herstellmethoden der Polyurethane sind allgemein bekannt und beispielsweise in der DE-A-19807754 näher beschrieben.

Geeignete wässrige Polyurethandispersionen haben einen Feststoffgehalt von bevorzugt 30 bis 70 Gew.-%.

Die wässrigen Polyurethandispersionen können weitere Zusatzstoffe, z.B. Verdicker, Verlaufshilfsmittel, Pigmente, Entschäumer oder Vernetzer enthalten.

Erfindungsgemäß enthalten sie mindestens einen Metalldeaktivator.

Metallionen katalysieren im allgemeinen die Zersetzung von Peroxiden und beschleunigen damit den Abbau von Polymeren, folglich sind Metalldeaktivatoren Substanzen, die den schädlichen Einfluß von Metallionen bezüglich des Abbaus von Polymeren vermindern, z.B. durch Komplexierung dieser Metallionen. Beispiele für Metalldeaktivatoren sind 2-(2-Benzimidazolyl)-phenol, 3-(2-Imidazolin-2-yl)-2-naphthol, 2-(2-Benzooxazolyl)-phenol, 4-Diethylamino-2,2'-dioxy-5-methylazobenzen, 3-Methyl-4-(2-oxy-5-methylphenylazo)-1-phenyl-5-pyrazolon, Tris(2-tert.butyl-4-thio(2'methyl-4'hydroxy-5'tert.butyl)-phenyl-5-methyl)phenylphosphit, Decamethylendicarboxydisalicyloylhydrazid, 3-Salycyloylamino-1,2,4-triazol, 2',3-Bis-((3-(3,5-de-tert.-butyl-4-hydroxyphenyl)propionyl))propionhydrazid, 2,2'Oxamidobis-(ethyl-3-(3,5-di-tert.-butyl-4-hydroxyphenyl)propionat). Weiter können allgemein Derivate des Hydrazins wie Adipinsäuredihydrazid bzw. Oxalsäuredihydrazid und Derivate des Oxamids als Metalldeaktivatoren fungieren.

Bevorzugte Metalldeaktivatoren sind Triazole und Triazolderivate. Triazole sind aus 2 C-Atomen und 3 N-Atomen gebildete heterocyclische 5-Ringsysteme, z.B.

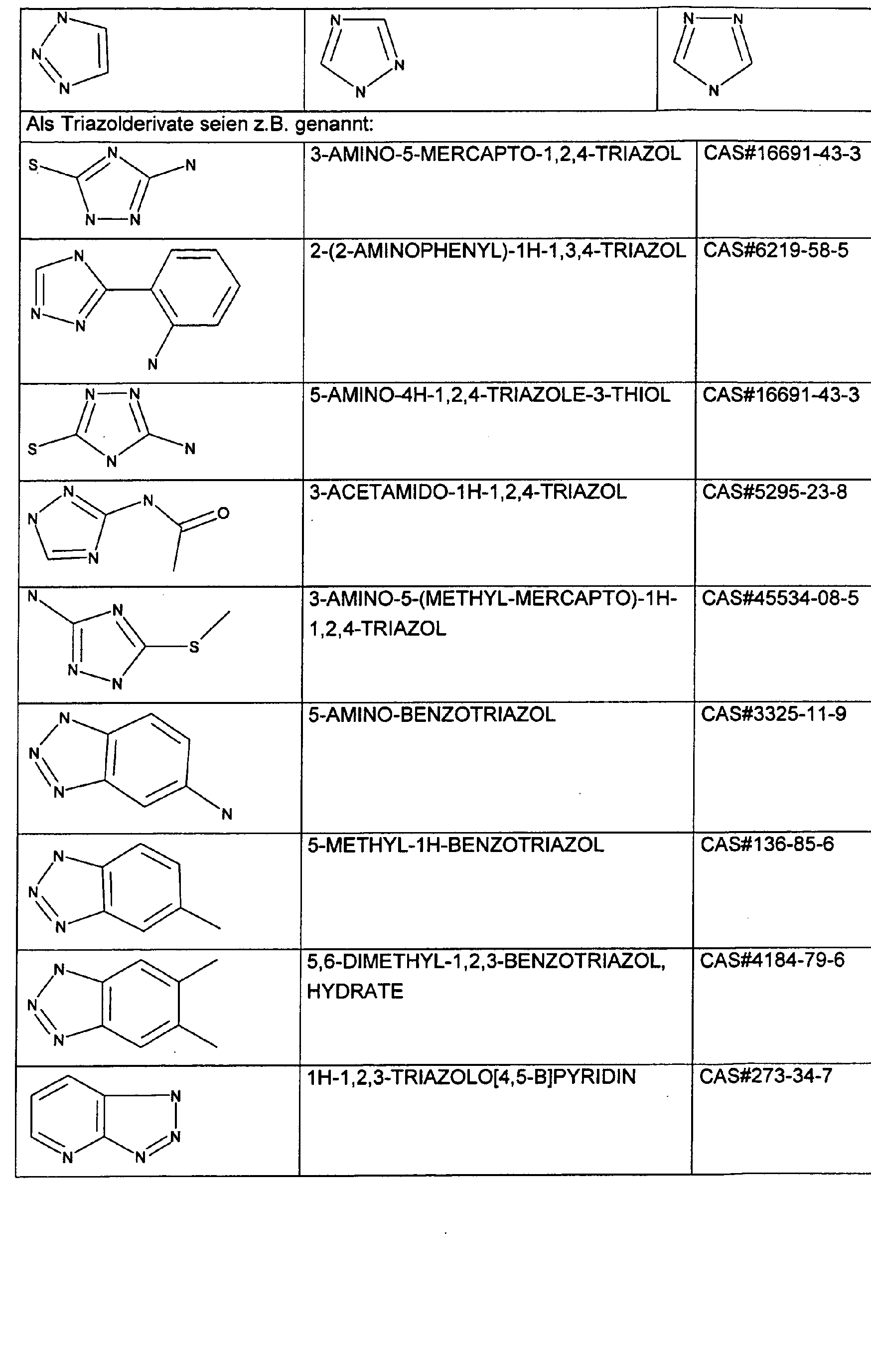

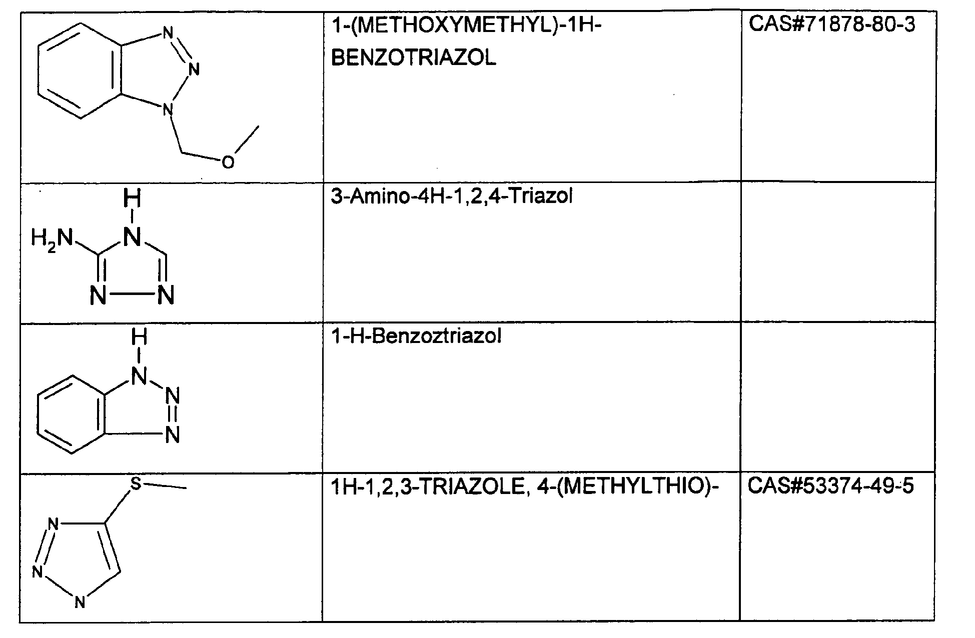

Weiter können als Triazol und/oder Triazoderivate die folgenden Verbindungen eingesetzt werden: Tinuvin®P (CAS reg.Nr. 2440-22-4), Tinuvin® 329 (CAS Reg.Nr. 3147-75-9), Tinuvin® 326 (CAS.Reg.Nr. 3896-11-5), Tinuvin ® 320 (CAS Reg.Nr. 3846-71-7), Tinuvin® 571 (CAS.Reg.Nr. 23328-53-2), Tinuvin® 328 (CAS.Reg.Nr. 25973-55-1), Tinuvin® 350 (CAS.Reg.Nr. 36437-37-3, Tinuvon® 327 (CAS.Reg.Nr. 3864-99-1), Tinuvin® 234 (CAS.Reg.Nr. 70321-86-7),Tinuvin® 360 (CAS.Reg.Nr.103597-45-1), Tinuvin® 840 (CAS.Reg.Nr. 84268-08-6), Tinuvin ® 384 Tinuvin® ist ein Handelsname der CIBA Specialty Chemicals, Basel, Schweiz.

Insbesondere sind Triazolderivate geeignet, die mindestens eine, vorzugsweise ein bis drei, besonders bevorzugt eine reaktive Gruppe enthalten, über die bei der späteren Verwendung oder bereits bei der Herstellung des Polyurethans eine Anbindung an das Polyurethan erfolgt.

Insbesondere handelt es sich um eine mit Isocyanat reaktive Gruppe, z.B. Hydroxygruppen, primäre oder sekundäre Aminogruppen, Epoxygruppen, Carboxylgruppen und Thioalkohole.

Besonders bevorzugt sind Triazolderivate mit Hydroxygruppen oder Aminogruppen, wozu auch sekundäre Aminogruppen zählen, welche selbst Bestandteil des Ringsystems sind.

Ganz besonders bevorzugt sind
4-Amino-1,2,4-Triazol
3-Amino-4H-1,2,4-Triazol und
1 H-Benzotriazol

Bei den Triazolen und Triazolderivaten handelt es sich im allgemeinen um niedermolekulare Verbindungen mit einem Molgewicht von 69 g/mol (Triazol) bis 1000 g/mol, insbesondere bis 500 g/mol, besonders bevorzugt bis 300 g/mol.

Die Menge der Triazole oder Triazolderivate beträgt vorzugsweise 0,1 bis 10 Gew.-Teile, besonders bevorzugt 0,1 bis 5 Gew.-Teile, ganz besonders bevorzugt 0,1 bis 3 Gew.-Teile auf 100 Gew.-Teile Polyurethan.

Die Triazole oder Triazolderivate können der Polyurethandisperison zu jeder Zeit zugesetzt werden.

Bevorzugt werden die Triazole oder Triazolderivate an das Polyurethan gebunden, z.B. bei der Herstellung des Polyurethan oder durch eine spätere Vernetzung oder polymeranaloge Umsetzung.

Triazolderivate mit reaktiven Gruppen können dazu als Aufbaukomponente Id oder le (siehe oben) bei der Herstellung des Polyurethans mitverwendet werden.

Die Triazole oder Triazolderivate können auch durch Mitverwendung sonstiger Vernetzungsmittel, z.B. von Polyisocyanaten an das Polyurethan gebunden werden.

Die erfindungsgemäßen Polyurethandispersionen werden vorzugsweise als Klebstoff, insbesondere Kaschierklebstoff verwendet.

Insbesondere werden sie als Kaschierklebstoff zur Verklebung von Kunststofffolien auf Metallsubstrate verwendet.

Als aufzukaschierender Kunststoff in den erfindungsgemäßen Materialien kommen allgemein bekannte thermoplastische Kunststoffe in Betracht, beispielsweise PVC, Polyethylen, Polypropylen, ABS, ASA, EVA, Polystyrol, Polyamid, Polycarbonat, PET, PBT, POM, SAN, Polybutadien, Polyisopren, Polyacrylnitril, bevorzugt thermoplastisches Polyurethan, das gegebenenfalls in Mischung mit mindestens einem weiteren thermoplastischen Kunststoff, beispielsweise einem der genannten thermoplastischen Kunststoffe vorliegen kann.

Als Metalle kommen bevorzugt elektrisch leitfähige Metalle oder Legierungen, besonders bevorzugt Kupfer, beispielsweise in für Kabel üblichen Reinheitsgraden, in Betracht.

Insbesondere eignen sich die erfindungsgemäßen Polyurethandispersionen als Kaschierklebstoff bei der Herstellung von Folienflachleitern und Leiterplatten.

Bei Leiterplatten handelt es sich üblicherweise um einen flächigen Träger, auf dem elektrische Leiterbahnen verlaufen, die elektronische Bauteile elektrisch leitend verbinden. Solche Leiterplatten sind allgemein bekannt und beispielsweise in üblichen elektrischen oder insbesondere elektronischen Geräten, insbesondere Computern enthalten. Erfindungsgemäß können diese Leiterplatten derart aufgebaut sein, dass die elektrischen Leiterbahnen, die die elektronischen Bauteile elektrisch leitend verbinden, mit einer Kunststofffolie kaschiert werden, wobei als Klebstoff Polyurethandispersionen, enthaltend den oder die Metallschutzmittel, verwendet werden. Beispielsweise können die Leiterplatten enthaltend die Leiterbahnen einseitig oder beidseitig mit einer Kunststofffolie bedeckt werden, die anschließend auf die Leiterbahnen mittels der erfindungsgemäßen Polyurethandispersionen aufkaschiert wird. Eine weitere Anwendung sind Steckermaterialien und Steckverbindungen zur Herstellung elektrischer Kontakte zweier Leiter.

Unter Folienflachleiter werden im allgemeinen flache, flexible Leiterbänder verstanden, die aus einem oder mehreren, bevorzugt parallel ausgerichteten, Metallbändern, die zwischen zwei Folien aus Kunststoff eingearbeitet werden, aufgebaut sind, so dass eine Isolierung erfolgt. Die Ausmaße der Folienflachleiter sind nicht begrenzt. Üblicherweise weisen sie je nach Verwendung eine Länge von 5 cm bis 100 m und eine Breite von 0,5 cm bis 30 cm auf. Das flache flexible Leiterband zeichnet sich durch gute Verarbeitbarkeit z.B. in Dachhimmeln, geringes Gewicht, kostengünstige Herstellung und einfache Verbindungstechnik aus. Aufgrund ihrer Verwendung z.B. im Automobilbau sind bezüglich der mechanischen, chemischen und thermischen Widerstandsfähigkeit an die Folienflachleiter eine ganze Reihe von Anforderungen gestellt. Bauartbedingt ist allerdings bei einem Folienflachleiter die Kontaktfläche zwischen dem Werkstoff Kupfer, der Kunststofffolie und der Klebstoffdispersion und überhaupt die Oberfläche der Leiterbahn besonders groß. Zudem ist die Wandstärke der Leiterbahn üblicherweise sehr gering, womit der Folienflachleiter besonders effektiv gegen Beschädigung und äußeren Angriff geschützt werden muss.

Üblicherweise umfasst der Folienflachleiter mindestens eine metallische Leiterbahn, die zwischen mindestens zwei Kunststofffolien positioniert ist. Gemäß der vorliegenden Erfindung werden die Kunststofffolien mittels der erfindungsgemäßen Polyurethan-dispersionen aufkaschiert. Die Folien weisen im allgemeinen eine Dicke von 1 µm bis 5 mm, bevorzugt von 10 µm bis 2 mm, besonders bevorzugt von 10 µm bis 1 mm, insbesondere von 25 µm bis 250 µm auf.

Als Metallband ist im allgemeinen jeder leitende Stoff geeignet. Bevorzugt werden aber Metalle, wie beispielsweise Eisen, Zink, Kupfer oder Legierungen davon verwendet, besonders bevorzugt wird Kupfer verwendet. Die Metallbänder weisen im allgemeinen eine Dicke von 1 µm bis 500 µm, bevorzugt von 10 µm bis 250 µm und besonders bevorzugt von 30 µm bis 100 µm auf. Zur Herstellung der erfindungsgemäßen Folienflachleiter sind mehrere Verfahren möglich. In einer bevorzugten Ausführungsform werden zunächst zwei, bevorzugt einseitig mit Klebstoff bestrichene Kunststofffolien bereit gestellt. Zwischen diese beiden Folien werden anschließend Metallbänder, beispielsweise 30 bis 100 µm dicke Kupferbändchen, eingearbeitet bzw. einlaminiert.

Bevorzugt beträgt die Breite des erfindungsgemäßen Folienflachleiters zwischen 0,5 cm und 30 cm, wobei die Dicke der metallischen Leiterbahnen bevorzugt zwischen 1 µm und 500 µm beträgt und die Dicke der Folien enthaltend thermoplastisches Polyurethan bevorzugt zwischen 10 µm und 2 mm liegt.

Die erfindungsgemäßen Folienflachleiter können vielseitig eingesetzt werden. Bevorzugt werden sie als flexible Leiter in Verkehrsmitteln, Elektroartikeln und Maschinen verwendet. Beispiele für geeignete Verkehrsmittel sind Kraftfahrzeuge, beispielsweise PKWs, Busse oder LKWs, Schienenfahrzeuge, Flugzeuge oder Schiffe. Beispiele für Elektroartikel sind Haushaltsgeräte, Fernseher, Stereoanlagen, Videorekorder, Computer und Zubehör, Drucker und Zubehör, Kopierer und Zubehör, Scanner und Zubehör, Schaltschränke und Steueranlagen. Beispiele für Maschinen sind Verpackungsmaschinen, Roboter, spanabhebende Maschinen, Werkzeugmaschinen, Spritzgussmaschinen, Extruder, Kalander, Folienblasmaschinen, CAD-Maschinen, Fräsen, Stanzen, Pressen, Drehmaschinen, Baumaschinen, z.B. Bagger, Radlader, Kräne, Förderanlagen, Flurförderfahrzeuge, Sortiermaschinen, Fließbänder, Prozessüberwachungsanlagen, und Prozessleitstände. Besonders bevorzugt sind Automobile, beispielsweise Lastkraftwagen, Busse und Personenkraftfahrzeuge, enthaltend die erfindungsgemäßen Folienflachleiter.

Durch die erfindungsgemäße Dispersion wird das mit der Kunststofffolie kaschierte Metall besonders gut gegen Korrosion geschützt.

Gleichzeitig werden die anwendungstechnischen Eigenschaften nicht oder allenfalls unwesentlich beeinträchtigt. Insbesondere die Klebekraft und die Haftung der Folie auf dem Metall sind sehr gut.

Das gleiche gilt auch für den Fall, dass die Triazole oder Triazolderivate an das Polyurethan gebunden sind.

### Beispiele

1. Herstellung der erfindungsgemäßen Klebstoffe
   0,2 g 1 H-Benztriazol werden in 100 g Luphen D 200A® gelöst. Zur Verdickung werden 1,5 g Sterocoll HAT® und zur Vernetzung 5 g Basonat F 200 WD® zugesetzt.
   Luphen D 200A® ist eine 40%ige anionische Polyester-Polyurethan-Dispersion der BASF AG.
   Sterocoll HT® ist ein Verdickungsmittel der BASF AG.
   Basonat F 200 WD® ist ein wasseremulgierbares Polyisocyanat auf Basis eines
   Biurets des Hexamethylendiisocyanats der BASF AG.
2. Vergleich
   Es wird verfahren wie in Beispiel 1, jedoch wird kein 1 H-Benztriazol zugesetzt.
   Eine Kunststofffolie (Hostafan BN 50® der Fa. Mitsubishi Polyester Films, Wiesbaden) wird mit den oben beschriebenen Dispersionen mit einem Auftragsgewicht von 50 g Trockenmasse/m² beschichtet. 4 cm breite Streifen dieser Folie werden auf eine 400 µm starke Kupferfolie bei einer Pressentemperatur von 100° 30 Sekunden lang mit einem Druck von 0,2 N/mm² aufkaschiert. Die Kaschierungen werden 24 Stunden lang bei Raumtemperatur und dann drei Tage lang bei 80°C und 80% relativer Feuchte in einem Klimaschrank gelagert. Hernach wird die Verfärbung der Kupferfolie per Augenschein beurteilt.
   Die Kupferfolie, die mit der Dispersion nach Beispiel 1 kaschiert wurde, zeigt keine Verfärbung.
   Die Kupferfolie, die mit der Dispersion nach dem Vergleichsbeispiel kaschiert wurde, zeigt eine dunkle Verfärbung.

## Patentansprüche

1. Wässrige Polyurethandispersionen, enthaltend einen Metalldeaktivator.

2. Wässrige Polyurethandispersionen gemäß Anspruch 1, **dadurch gekennzeichnet, dass** es sich bei dem Metalldeaktivator um eine chemische Verbindung mit mindestens einem Triazolring handelt.

3. Wässrige Polyurethandispersionen gemäß Anspruch 2, **dadurch gekennzeichnet, dass** die Verbindung weiterhin mindestens eine funktionelle Gruppe enthält, die mit Isocyanat reagieren kann.

4. Wässrige Polyurethandispersionen gemäß Anspruch 2 oder 3, **dadurch gekennzeichnet, dass** die Verbindung an das dispergierte Polyurethan gebunden ist.

5. Wässrige Polyurethandispersionen gemäß einem der Ansprüche 1 bis 4, **dadurch gekennzeichnet, dass** der Gehalt der Verbindung 0,01 bis 3 Gew. Teile, bezogen auf 100 Gew. Teile des in der Dispersion dispergierten Polyurethans beträgt.

6. Wässrige Polyurethandispersionen gemäß einem der Ansprüche 1 bis 5, **dadurch gekennzeichnet, dass** die Polyurethandispersionen Vernetzer, insbesondere Polyisocyanate, enthalten.

7. Verwendung der wässrigen Polyurethandispersionen gemäß einem der Ansprüche 1 bis 6 als Kaschierklebstoff zur Verklebung von Kunststofffolien auf Metallsubstrate.

8. Verwendung der wässrigen Polyurethandispersionen gemäß Anspruch 7 zur Herstellung von Folienflachleitern und Leiterplatten.

9. Folienflachleiter und Leiterplatten, erhältlich durch Verwendung gemäß Anspruch 8.
